# DEMANDE DE BREVET EUROPEEN

(11) **EP 4 185 092 A1**
(43) Date de publication de la demande: **24.05.2023**
(21) Numéro de dépôt: 22207831.3
(22) Date de dépôt: 16.11.2022
(51) Int. Cl.: H10N 60/01

(54) **PROCEDE DE RÉALISATION D'INTERCONNEXIONS SUPRACONDUCTRICES**

(30) Priorité: 18.11.2021 FR 2112216
(71) Demandeur: Commissariat à l'Énergie Atomique et aux Énergies Alternatives, 75015 Paris (FR)
(72) Inventeur: POSSEME, Nicolas, 38054 Grenoble cedex 09 (FR); LE ROYER, Cyrille, 38054 Grenoble cedex 09 (FR); NEMOUCHI, Fabrice, 38054 Grenoble cedex 09 (FR); SEGAUD, Roselyne, 38054 Grenoble cedex 09 (FR)
(74) Mandataire: Brevalex

(57) **Abrégé**

L'invention concerne un dispositif d'interconnexion entre des lignes (114, 126, 126') en matériau supraconducteur et au moins un via (108) en contact avec ces lignes, comportant :
a) un premier substrat (S), qui porte au moins une première ligne (114) en un premier matériau supraconducteur;
b) au moins un premier via (108) en un deuxième matériau supraconducteur, différent du premier matériau supraconducteur, ladite au moins une première ligne (114) étant disposée entre ledit premier substrat (S) et ledit premier via (108);
c) au moins une deuxième ligne (126, 126') au-dessus dudit premier via et en contact avec celui-ci.

## Description

### DOMAINE TECHNIQUE ET ART ANTERIEUR

L'invention concerne la réalisation d'interconnexions entre des lignes en matériau supraconducteur, ces lignes étant situées à différents niveaux d'un empilement formant un circuit.

Le développement des Qbits de spin et des Qbit supraconducteurs demande la mise en place d'un routage BEOL (« Back end of line ») compatible radiofréquence et fonctionnant à très basse température.

Il existe à ce jour des intégrations BEOL basées sur des matériaux supraconducteurs (Nb), mais ces empilements technologiques ne sont pas adaptés aux exigences des nœuds technologiques avancés, par exemple en technologie FD-SOI 28 nm.

On connait l'article de Sergey K. Tolpygo et al., intitulé « Advanced Fabrication Processes for Superconducting Very Large-Scale Integrated Circuits », paru dans IEEE Transactions On Applied Superconductivity, Vol. 26, NO. 3, April 2016, ainsi que celui de S. Nagasawa et al. intitulé « New Nb multi-layer fabrication process for large-scale SFQ circuits », paru dans Physica C 469 (2009) 1578-1584.

Les techniques décrites dans ces documents ne permettent pas d'atteindre des petites dimensions (et notamment des dimensions entre vias inférieures au µm). La densité de connexion est également insuffisante. De plus, la topographie est trop importante pour multiplier l'empilement de lignes d'interconnexion et donc adresser un niveau de complexité élevé.

Il se pose donc le problème de trouver un autre procédé de réalisation d'interconnexions entre des lignes en matériau supraconducteur.

On connaît par ailleurs des techniques de réalisation d'interconnexions entre des lignes de matériaux métalliques classiques (en matériaux non supra-conducteurs).

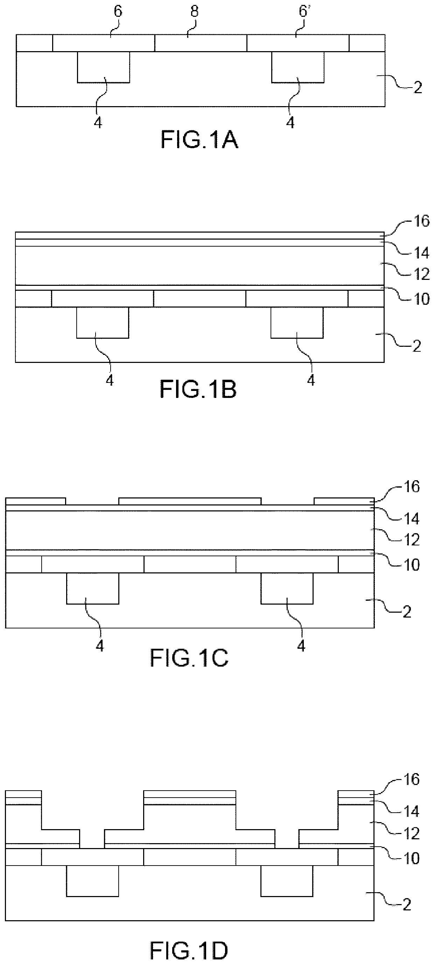

Un 1^{er} exemple d'une telle technique, de type « damascène », est illustré sur les figures 1A- 1E, pour des lignes en cuivre.

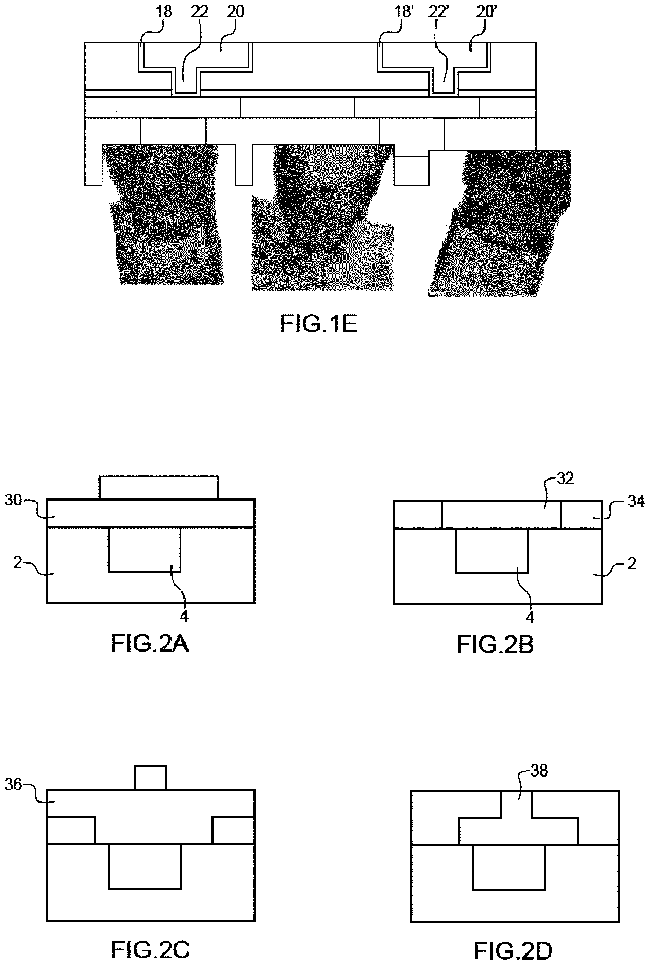

Cette technique comporte :
- la réalisation, sur un substrat 2 par exemple en matériau diélectrique tel que du SiO₂, et pouvant comporter par exemple des plots 4, d'un niveau inférieur de pistes métalliques 6, 6' séparées par des zones 8 en matériau diélectrique (figure 1A) ;
- le dépôt, sur l'ensemble précédemment obtenu, d'une couche d'arrêt de gravure 10 (p.ex. en SiCN/SiN), puis d'une couche diélectrique 12, dont l'épaisseur est égale à celle d'une ligne supérieure (à former) de pistes métalliques et d'un via (à former également) qui relie une de ces lignes supérieures et une des pistes 6, 6' ; éventuellement une couche d'oxyde SiO₂ 14 est déposée sur la couche diélectrique 12 et enfin une couche 16 de masque dur en TiN est déposée (figure 1B);
- la réalisation d'une étape de lithographie dans la couche 16 (figure 1C), suivie de la gravure, dans la couche 12, des lignes du niveau métallique supérieur puis des vias (figure 1D) ;
- le dépôt d'une couche 18, 18' de barrière (en Ta ou TaN) d'anti diffusion du cuivre sur les surfaces libres des zones gravées, puis le remplissage de ces zones gravées par dépôt du cuivre pour former les pistes métalliques 20, 20' et les vias 22, 22' proprement dits; l'ensemble peut être planarisé par polissage mécanochimique (technique dite « CMP ») (figure 1E).

Le problème de cette technique est que la présence de la couche 18, 18' dans les zones de contact entre vias 22, 22' et pistes 6, 6' du niveau inférieur, augmente la résistivité ainsi que la constante de temps RC du système. Le contact du via avec les lignes inférieures 6, 6' n'est donc pas bon.

Par ailleurs, si le matériau diélectrique 12 est de type « low k », les propriétés de ce matériau peuvent être modifiées lors des étapes de gravure ; en particulier, il peut y avoir transformation d'une partie de ce matériau en SiO₂, donc augmentation du coefficient k, ce qui entraîne une augmentation de la constante de temps RC du système final.

Un 2^{ème} exemple d'une technique connue est illustré sur les figures 2A- 2C.

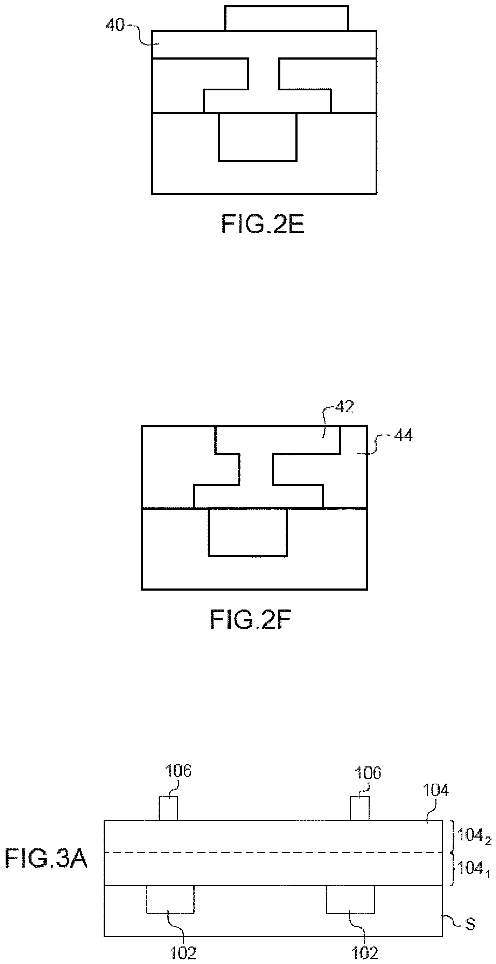

Cette technique comporte :
- la réalisation, sur un substrat 2 par exemple en matériau diélectrique tel que du SiO₂, et pouvant comporter par exemple des plots 4, d'une 1^{ère} couche métallique 30 dans laquelle une ou des lignes métalliques 32 sont gravées, et de part et d'autre desquelles un matériau diélectrique 34 est déposé (figure 2A);
- la réalisation, sur l'ensemble précédemment obtenu, d'une 2^{ème} couche métallique 36 (figure 2C) dans laquelle un ou des vias 38 sont réalisés (figure 2D);
- la réalisation, sur l'ensemble précédemment obtenu, d'une 3^{ème} couche métallique 40 (figure 2E) dans laquelle une ou des lignes métalliques 42 sont gravées, et de part et d'autre desquelles un matériau diélectrique 44 est déposé (figure 2F).

Cette deuxième technique comporte un nombre plus important d'étapes que la première technique présentée ci-dessus, et un nombre plus important d'étapes de polissage, ce qui entraîne une dispersion des épaisseurs des différentes couches.

Il se pose donc le problème de trouver un nouveau procédé permettant la réalisation de lignes en matériau supraconducteur, ces lignes étant situées à différents niveaux d'un empilement formant un circuit et étant reliée entre elles par des vias en même matériau supraconducteur que les lignes.

### EXPOSE DE L'INVENTION

L'invention a d'abord pour objet un dispositif d'interconnexion entre des lignes en matériau supraconducteur et au moins un via en contact avec ces lignes, comportant :
a) un premier substrat, qui porte au moins une première ligne en un premier matériau supraconducteur;
b) au moins un premier via en matériau supraconducteur, par exemple en un deuxième matériau supraconducteur différent du premier matériau supraconducteur, ladite au moins une première ligne étant disposée entre ledit premier substrat et ledit premier via;
c) au moins une deuxième ligne au-dessus dudit premier via et en contact avec celui-ci. Chaque matériau supra-conducteur peut être choisi parmi le V₃Si, le CoSi₂, le Nb₃Ge, le TiN, le NbN, le Al, le TaN.

Par exemple, le premier matériau supraconducteur est en aluminium, ou comporte de l'aluminium, et le deuxième matériau supraconducteur est en TiN ou TaN, ou comporte du TiN ou TaN.

Un tel dispositif peut en outre comporter en outre un matériau diélectrique qui forme un enrobage de ladite première ligne et un enrobage, par exemple au moins partiel et/ou latéral, dudit premier via.

Ce matériau diélectrique peut être:
- à constante diélectrique relative k <7 ;
- et/ou choisi parmi la liste suivante : SiN, SiCN, SiO₂, SiCOH ou SiCOH poreux.

Un dispositif selon l'invention peut comporter:
- plusieurs premières lignes, selon un pas inférieur à 500 nm, de préférence compris entre 56 nm et 500nm ;
- et/ou au moins une première ligne d'épaisseur H₁, par exemple comprise entre 40 nm et 300 nm ; au moins un via, en contact avec ladite première ligne, peut être par exemple d'épaisseur comprise entre H₁ et H₁/2.

Ledit premier substrat d'un dispositif selon l'invention peut comporter au moins une partie d'un circuit, par exemple au moins un plot de contact, avec laquelle ladite première ligne est en contact.

L'invention a également pour objet un procédé de réalisation de lignes en matériau supraconducteur et de via(s) reliant ces lignes.

Selon un aspect, un tel procédé comporte :
a) la formation, sur un premier substrat, d'une première couche supraconductrice en au moins un matériau supraconducteur, d'une épaisseur au moins égale à l'épaisseur d'une première ligne et d'un premier via;
b) la gravure de ladite couche supraconductrice pour former d'abord au moins un premier via; cette étape est par exemple réalisée par gravure partielle de ladite couche supraconductrice, laissant intacte une partie de celle-ci ;
c) puis la gravure de ladite couche pour former au moins une première ligne entre ledit premier substrat et ledit premier via ; cette étape est par exemple réalisée par lithographie avec gravure totale de parties exposées de ladite couche supraconductrice jusqu'au substrat ;
d) la formation d'au moins une deuxième ligne au-dessus dudit premier via et en contact avec celui-ci.

Le via vertical est donc en contact avec deux lignes situées à deux niveaux différents.

De préférence, la première couche supraconductrice comporte une première sous-couche en un premier matériau supraconducteur, dans laquelle ladite première ligne est réalisée et une deuxième sous-couche en un deuxième matériau supraconducteur, différent du premier matériau supraconducteur, dans laquelle ledit via est réalisé.

Le premier substrat (S) peut comporter au moins une partie d'un circuit, par exemple au moins un plot de contact, avec laquelle la première ligne peut être en contact.

Le matériau supra-conducteur peut être choisi parmi le V₃Si, le CoSi₂, le Nb₃Ge, le TiN, le NbN, le Al, le TaN. Il peut être déposé par exemple par PVD ou CVD.

Par exemple la sous-couche en un premier matériau supraconducteur, dans laquelle ladite première ligne est réalisée, est en aluminium, ou comporte de l'aluminium, et la deuxième sous-couche en un deuxième matériau supraconducteur est en TiN ou TaN, ou comporte du TiN ou TaN.

La gravure de la deuxième sous-couche supraconductrice pour former le via est de préférence arrêtée sur la surface supérieure de la première sous-couche.

L'étape d) de formation d'au moins une deuxième ligne peut comporter la formation préalable d'au moins un deuxième via, puis de la deuxième ligne.

Un procédé selon l'invention peut comporter, entre les étapes c) et d), une étape d'enrobage de ladite première ligne et un enrobage, par exemple au moins partiel et/ou latéral, dudit premier via avec un matériau diélectrique, formant un deuxième substrat. Ce matériau diélectrique peut être par exemple à constante diélectrique relative k faible, par exemple k<7. Il peut être choisi parmi la liste suivante : SiN, SiCN, SiO₂, SiCOH ou SiCOH poreux.

Dans un procédé selon l'invention, l'étape d) peut comporter:
- le dépôt sur le deuxième substrat d'une deuxième couche supraconductrice en au moins un matériau supraconducteur, par exemple l'un des matériaux supraconducteurs mentionnés ci-dessus, d'une épaisseur au moins égale à l'épaisseur d'une deuxième ligne, et éventuellement d'un deuxième via;
- la gravure de la deuxième couche supraconductrice pour éventuellement former le deuxième via, et pour former au moins ladite deuxième ligne, en contact avec ledit premier via.

Cette deuxième couche supraconductrice peut comporter une première sous-couche en un premier matériau supraconducteur, dans laquelle ladite deuxième ligne est réalisée et une deuxième sous-couche en un deuxième matériau supraconducteur, qui peut être différent du premier matériau supraconducteur, dans laquelle ledit via est réalisé. Par exemple la sous-couche en un premier matériau supraconducteur, dans laquelle ladite deuxième ligne est réalisée, est en aluminium, et la deuxième sous-couche en un deuxième matériau supraconducteur est en TiN ou TaN.Là encore, la gravure de la deuxième sous-couche supraconductrice pour former le via est de préférence arrêtée sur la surface supérieure de la première sous-couche.

Un procédé selon l'invention peut comporter :
- la formation de plusieurs premières lignes, selon un pas inférieur à 500 nm, de préférence compris entre 56 nm et 500 nm ;
- et/ou la formation d'au moins une première ligne d'épaisseur H₁ par exemple comprise entre 40 nm et 300 nm ; au moins un via, en contact avec ladite première ligne, peut avoir une épaisseur comprise entre H₁ et H₁/2.

Un procédé selon l'invention nécessite moins d'étapes qu'un procédé connu tel que celui décrit ci-dessus en lien avec les figures 2A-2D.

De plus, dans la mesure où les via et les pistes du niveau métallique supérieur sont réalisés par des gravures successives, sans nécessité de dépôt de couches supplémentaires, le problème de dispersion des épaisseurs des couches n'a qu'un impact limité.

### BREVE DESCRIPTION DES DESSINS

Des exemples de réalisation de l'invention seront maintenant décrits en référence aux dessins annexés dans lesquels :
[Fig. 1A] - [Fig. 1E] et [Fig. 2A] - [Fig. 2F] représentent des exemples de procédé connus;
[Fig. 3A] - [Fig. 3H] représentent un exemple de procédé et de dispositif selon l'invention;
[Fig. 4A] - [Fig. 4B] représentent une variante d'un procédé et de dispositif selon l'invention.

Dans les figures des éléments techniques similaires ou identiques sont désignés par les mêmes numéros de référence.

### DESCRIPTION DETAILLEE DE MODES DE REALISATION

Un exemple de réalisation d'un procédé selon l'invention est représenté en figures 3A-3G.

On réalise, sur un substrat S, par exemple en matériau diélectrique tel que du SiO₂, et pouvant comporter au moins une partie ou des éléments d'un circuit, par exemple par exemple des plots 102 de contact, un dépôt d'une couche 104 de matériau supraconducteur (figure 3A).

Cette couche 104 a une épaisseur de préférence équivalente ou égale à la somme des épaisseurs:
- de la (ou des) piste(s) ou ligne(s), à réaliser dans la partie référencée 104₁ de cette couche 104, qui forment le premier niveau métallique (ou niveau inférieur) ;
- et du ou des via(s), à réaliser dans la partie référencée 104₂ de cette même couche 104 et qui seront en contact avec la (ou les) ligne(s).

Dans cet exemple :
- le matériau supraconducteur peut-être du niobium (Nb), mais d'autres exemples de matériaux supraconducteurs pouvant être mis en oeuvre sont donnés plus loin ;
- la couche 104 est constituée d'un seul matériau supraconducteur, mais on verra plus loin qu'elle peut comporter une première couche ou sous-couche en un premier matériau supraconducteur pour la réalisation du niveau métallique inférieur et une deuxième couche ou sous-couche en un deuxième matériau supraconducteur, différent du premier matériau supraconducteur, cette deuxième couche étant en contact direct avec la première couche et étant destinée à la réalisation du ou des via.

On réalise ensuite sur cette couche 104 un masque (dur ou en résine) 106 en vue de réaliser une gravure du ou des via(s).

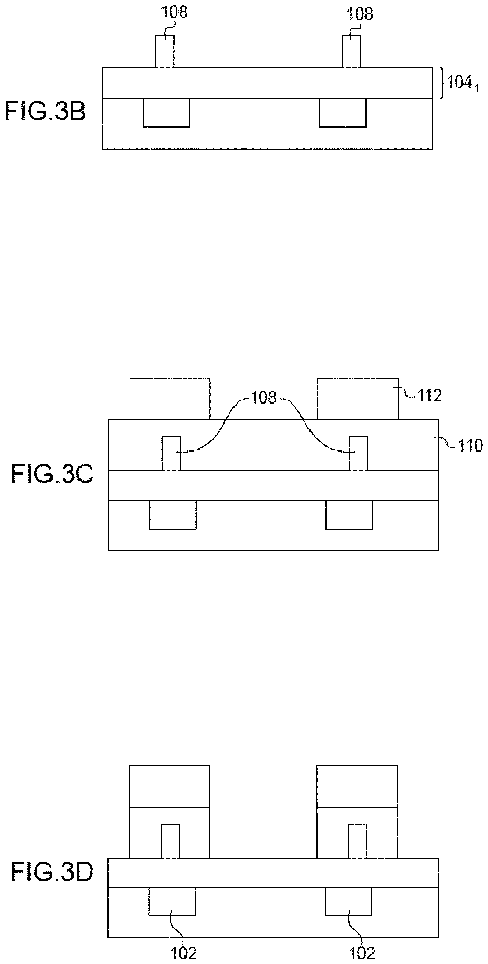

Après gravure partielle de la couche 104 et retrait du masque, on obtient donc la structure de la figure 3B qui comporte l'âme métallique des vias 108 (gravés dans la partie référencée 104₂ de la couche initiale 104) sur la partie référencée 104₁ dans laquelle les lignes inférieures vont être réalisées (après une étape de gravure ultérieure).

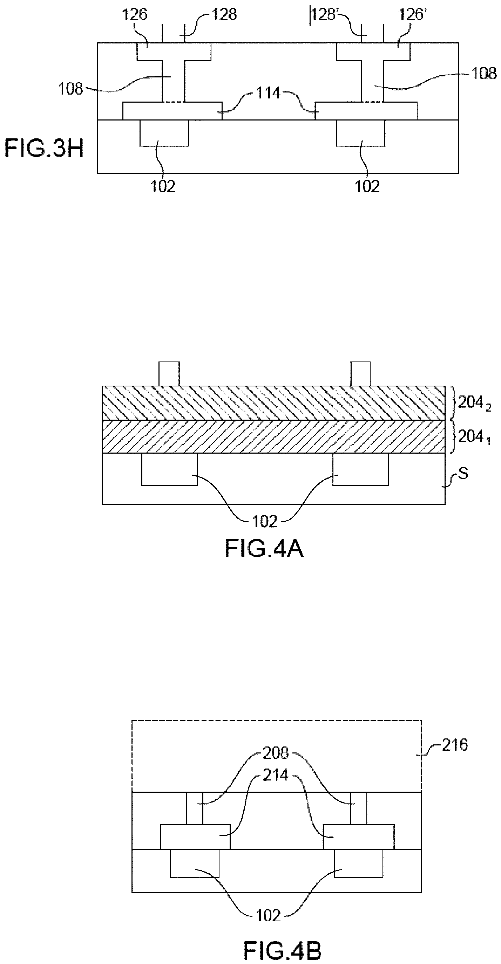

Cette étape étant réalisée par gravure partielle de la couche supraconductrice, elle laisse intacte une partie de celle-ci. Dans le cas, mentionné ci-dessus et également décrit en lien avec les figures 4A-4B, où la couche 104 comporte 2 sous-couches en matériau supraconducteurs différents, la référence 104₁ des figures 3A et 3B désigne la première couche ou sous-couche en un premier matériau supraconducteur (pour la réalisation du niveau métallique inférieur) et la référence 104₂ désigne la deuxième couche ou sous-couche en un deuxième matériau supraconducteur, différent du premier matériau supraconducteur, cette deuxième couche étant en contact direct avec la première couche et étant destinée à la réalisation du ou des via.

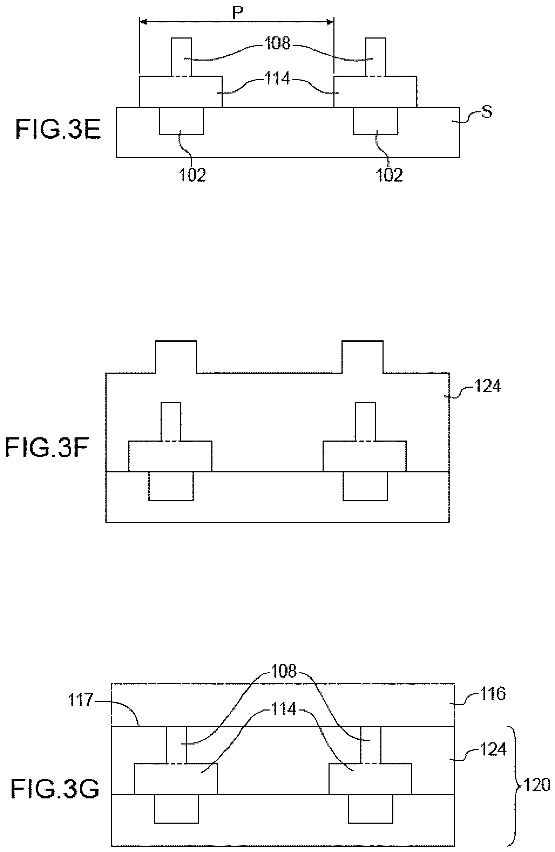

En vue de réaliser la définition des lignes du niveau inférieur, la partie référencée 104₁ de la couche initiale 104 ainsi que l'âme métallique des vias 108 peuvent être recouverts d'une couche de résine 110 et d'une couche 112 de type BARC (« Bottom Anti Reflectant Coating ») ou SOC (« Spin on Carbon »). Une étape de photolithographie (figure 3C) puis de gravure de la couche de résine 110 (figure 3D) mais également de la partie référencée 104₁ de la couche initiale 104 (figure 3E) permettent de définir la ou les piste(s) métallique(s) 114 du niveau inférieur. Au moins une telle piste métallique 114 peut être en contact avec, par exemple, au moins une partie ou un élément d'un circuit réalisé dans le substat S, par exemple un ou des plot(s) 102 de contact. Cette étape peut être réalisée par lithographie avec gravure totale des parties exposées de la couche supraconductrice, jusqu'au substrat S. La gravure de cette étape peut être suivie d'une étape de nettoyage. L'ensemble peut être recouvert d'une couche diélectrique 124 (figure 3F), laquelle est ensuite planarisée (figure 3G), par exemple jusqu'au sommet du ou des vias 108. Un nouveau substrat 120 est alors formé dont la surface supérieure 117 comporte une alternance de zones en matériau diélectrique et de zones en matériau supraconducteur. Le matériau diélectrique 124 forme un enrobage de la ou des première(s) ligne(s) ou piste(s) métallique(s) 114 et un enrobage au moins partiel et/ou latéral du ou des premier(s) via 108 (le sommet des via est libre de matériau diélectrique). Un deuxième niveau (ou niveau supérieur) de piste(s) (ou de ligne(s)) en matériau supraconducteur peut être formé sur cette surface supérieure 117, ces pistes étant en contact direct avec les vias 108. Concernant le matériau diélectrique 124, il est de préférence à constante diélectrique k faible, par exemple k<7. Il peut être choisi parmi la liste suivante SiN, SiCN, SiO₂, SiCOH ou SiCOH poreux. Si un matériau « Low-k » poreux est choisi, la technique selon l'invention n'entraîne pas de modification des propriétés de ce matériau, contrairement à l'approche « damascène » connue (décrite ci-dessus en lien avec les fig.1A-1E).

Les étapes décrites ci-dessus (figures 3A- 3G) peuvent être itérées sur ce substrat 120: on peut ainsi déposer sur la surface supérieure 117 un niveau métallique supérieur comportant au moins une couche métallique 116 (figure 3G) en matériau supraconducteur dont l'épaisseur sera fonction de la présence, ou pas, d'un autre niveau de vias au-dessus de ce niveau métallique supérieur. L'enchaînement des étapes décrites ci-dessus à partir de la figure 3A peut donc être de nouveau effectué ; par exemple, une étape de photolithographie, puis de gravure permet de former les pistes 126, 126' du niveau supérieur (figure 3H). Éventuellement, un ou des via 128, 128' sont formés préalablement aux pistes 126, 126'. La figure 3H représente une structure (un dispositif d'interconnexion entre des lignes en matériau supraconducteur et au moins un via en contact avec ces lignes) qui peut être obtenue à partir d'un procédé selon l'invention, dans laquelle des vias 108 relient des lignes 114 d'un niveau métallique inférieur et des lignes 126, 126' d'un niveau métallique supérieur.

Le matériau supraconducteur utilisé dans un procédé ou un dispositif selon l'invention peut-être du Niobium ; en variante il peut être choisi par exemple parmi la liste suivante (derrière chaque matériau, on a indiqué une ou 2 technique(s) de dépôt possible(s), une température ou une gamme de températures possibles pour ce dépôt et, éventuellement, une gamme de températures pour un recuit): V₃Si (PVD à température ambiante, recuit à 500-900°C), CoSi₂ (PVD à température ambiante, recuit à 600-900° C), Nb₃Ge (PVD à température ambiante), TiN (PVD ou CVD à température entre température ambiante et 400°C), NbN (PVD ou CVD à température ambiante, recuit à 500-900° C), Al (PVD à température entre température ambiante et 450°C), TaN (PVD à température ambiante entre 20 et 90°C ou CVD, avec une température maximale de 400°C).

Dans cet exemple de réalisation et dans la ou les variante(s) exposée(s) ci-dessous :
- dans le cas du TiN, la gravure est par exemple réalisée par une chimie chlorée ; on peut également se reporter à l'article de J.Tonotani et al. intitulé « Dry etching characteristics of TiN film using Ar/CHF3, Ar/Cl2, and Ar/BCl3 gas chemistries in an inductively coupled plasma », paru dans Journal of Vacuum Science & Technology B: Microelectronics and Nanometer Structures Processing, Measurement, and Phenomena 21, 2163 (2003); doi: 10.1116/1.1612517 ;
- dans le cas du NbN, la gravure est par exemple réalisée par un gaz fluoré (par exemple à base de SF₆ ou de CF₄).

On peut également se reporter à l'article de Qing Zhong, et al. intitulé « Study of Dry Etching Process Using SF6 and CF4/O2 for Nb/NbxSi1-x/Nb Josephson-Junction Fabrication », 978-1-4673-0442-9/12/$31.00, July 2012, IEEE, p. 46-47 ; CPEM Digest (Conference on Precision Electromagnetic Measurements), DOI:10.1109/CPEM.2012.6250653.

La personne du métier adaptera les conditions de gravure indiquées ci-dessus et/ou dans les articles cités ci-dessus pour graver les différents niveaux et/ou pour graver d'autres matériaux, y compris pour les variantes exposées ci-dessous.

En variante d'un procédé ou d'un dispositif selon l'invention et décrit ci-dessus, il est possible d'utiliser 2 matériaux supraconducteurs différents (figure 4A) pour une ou plusieurs des couches supraconductrices 104, 116 :
- un premier matériau supraconducteur pour former une première couche 204₁, en vue de la réalisation des lignes du niveau métallique inférieur ;
- et un deuxième matériau supraconducteur, différent du premier, pour former une deuxième couche 204₂, pour la réalisation des vias.

Chacun de ces matériaux supraconducteurs peut être choisi dans la liste proposée ci-dessus. Cette variante permet un meilleur contrôle d'arrêt de la gravure (par la surface supérieure de la couche 204₁) lors de la gravure des vias 208. L'enchaînement des étapes est ensuite celui décrit ci-dessus en lien avec les figures 3B-3G et conduit à la structure de la figure 4B, dans laquelle le matériau supraconducteur constitutif des vias 208 est en contact direct avec le matériau supraconducteur constitutif des lignes 214. Il est ensuite possible de former un niveau métallique supérieur comportant une couche métallique 216 (figure 4B) en un matériau supraconducteur, par exemple comportant 2 sous couches supra - conductrices (comme en figure 4A) dont l'épaisseur totale sera fonction de la présence, ou pas, d'un niveau supérieur de via. Une structure identique ou similaire à celle de la figure 3H peut donc être obtenue avec 2 matériaux supraconducteurs différents, par exemple l'un pour les pistes métalliques 114, 126, 126' et l'autre pour les vias 108, 128, 128' ; là encore, il s'agit d'un dispositif d'interconnexion entre des lignes en matériau supraconducteur et au moins un via en contact avec ces lignes. Avantageusement le deuxième matériau supraconducteur de la deuxième sous-couche 204₂ (ou 104₂) pour la réalisation des vias, est en TiN ou TaN, ou comporte du TiN ou du TaN. En effet, les inventeurs ont constaté que la qualité supraconductrice de ces matériaux se dégradait beaucoup moins que celle d'autres matériaux supraconducteurs avec la réduction des dimensions du matériau. L'un ou l'autre de ces matériaux conserve donc de bonnes propriétés une fois les vias formés. Par ailleurs, ces matériaux sont facilement intégrables dans un procédé microélectronique.

Avantageusement, et en association avec le TiN ou TaN, le premier matériau supraconducteur 204₁ (ou 104₁) destiné à former les lignes est de l'aluminium, ou comporte de l'aluminium, qui est également facilement intégrable dans un procédé microélectronique et qui a une bonne sélectivité de gravure par rapport à celle du TiN ou du TaN.

Quel que soit le mode de réalisation d'un procédé ou d'un dispositif selon l'invention :
- on met en oeuvre moins d'étapes que la technique décrite ci-dessus en lien avec les figures 2A-2F; en effet, au cours d'une même étape, on définit un niveau métallique (en un seul matériau supraconducteur ou en deux matériaux supraconducteurs) dans lequel des lignes seront réalisées, mais également des vias ;
- on réalise un élément supraconducteur ayant une forme en «T » inversé (voir sur les figures 3F et 3G les pistes de la ligne inférieure sont formées après les vias ; voir les dispositif des figures 3H et 4B), la technique décrite ci-dessus en lien avec les figures 1D et 1E réalisant d'abord une forme en « T », avec, en outre, les problèmes de contact déjà évoqués ci-dessus et liés à la présence de la couche 18, 18'.

Quel que soit le mode de réalisation mis en oeuvre, l'invention permet de réaliser:
- une pluralité, ou même un réseau, de pistes ayant un pas p (figure 3E) inférieur à 1 µm, ou inférieur à 500 nm, ou compris entre 500 nm et 56 nm, ou pouvant même descendre à environ 50 nm; ce pas p mesure, parallèlement à la surface du substrat S sur laquelle le dépôt métallique est réalisé, la distance entre parties identiques ou similaires de 2 pistes voisines ;
- une ou des pistes 114 ayant une hauteur H₁, mesurée à partir de ladite surface du substrat S et perpendiculairement à celle-ci, comprise par exemple entre 40 nm et 300 nm ; les via 108 peuvent avoir une hauteur H₂, mesurée suivant la même direction, comprise entre H₁ et H₁/2.

## Revendications

1. Dispositif d'interconnexion entre des lignes (114, 126, 126') en matériau supraconducteur et au moins un via (108) en contact avec ces lignes, comportant :
a) un premier substrat (S), qui porte au moins une première ligne (114) en un premier matériau supraconducteur;
b) au moins un premier via (108) en un deuxième matériau supraconducteur, différent du premier matériau supraconducteur, ladite au moins une première ligne (114) étant disposée entre ledit premier substrat (S) et ledit premier via (108);
c) au moins une deuxième ligne (126, 126') au-dessus dudit premier via et en contact avec celui-ci.

2. Dispositif selon la revendication 1, chaque matériau supra-conducteur étant choisi parmi le V₃Si, le CoSi₂, le Nb₃Ge, le TiN, le NbN, le Al, le TaN.

3. Dispositif selon la revendication 2, le premier matériau supraconducteur étant en aluminium, et le deuxième matériau supraconducteur étant en TiN ou TaN.

4. Dispositif selon l'une des revendications 1 à 3, comportant en outre un matériau diélectrique (124) qui forme un enrobage de ladite première ligne (114) et un enrobage au moins partiel et/ou latéral dudit premier via (108).

5. Dispositif selon la revendication 4, le matériau diélectrique (124) étant :
- à constante diélectrique relative k <7 ;
- et/ou choisi parmi la liste suivante : SiN, SiCN, SiO₂, SiCOH ou SiCOH poreux.

6. Dispositif selon l'une des revendications 1 à 5, comportant :
- plusieurs premières lignes, selon un pas inférieur à 500 nm, de préférence compris entre 56 nm et 500nm.
- et/ou au moins une première ligne (114) d'épaisseur H₁, par exemple comprise entre 40 nm et 300 nm, au moins un via (108), en contact avec ladite première ligne (114), étant par exemple d'épaisseur comprise entre H₁ et H₁/2.

7. Dispositif selon l'une des revendications 1 à 6, ledit premier substrat (S) comportant au moins une partie d'un circuit, par exemple au moins un plot (102) de contact, avec laquelle ladite première ligne (114) est en contact.

8. Procédé de réalisation de lignes (114, 126, 126') en matériau supraconducteur et de vias (108) en contact avec ces lignes, comportant :
a) la formation, sur un premier substrat (S), d'une première couche supraconductrice (104) en au moins un matériau supraconducteur, d'une épaisseur au moins égale à l'épaisseur d'une première ligne (114) et d'un premier via (108);
b) la gravure de ladite couche supraconductrice (104) pour former d'abord au moins un premier via (108);
c) puis la gravure de ladite couche pour former au moins une première ligne (114) entre ledit premier substrat (S) et ledit premier via (108), la première couche supraconductrice comportant une première sous-couche (104₁, 204₁) en un premier matériau supraconducteur, dans laquelle ladite première ligne (114) est réalisée et une deuxième sous-couche (104₂, 204₂) en un deuxième matériau supraconducteur, différent du premier matériau supraconducteur, dans laquelle ledit via (108) est réalisé,d) la formation d'au moins une deuxième ligne (126, 126') au-dessus dudit premier via et en contact avec celui-ci.

9. Procédé selon la revendication 8, chaque matériau supra-conducteur étant choisi parmi le V₃Si, le CoSi₂, le Nb₃Ge, le TiN, le NbN, l'Al, le TaN, par exemple la sous-couche (104₁, 204₁) en un premier matériau supraconducteur, dans laquelle ladite première ligne (114) est réalisée, étant en aluminium, et la deuxième sous-couche (104₂, 204₂) en un deuxième matériau supraconducteur étant en TiN ou TaN.

10. Procédé selon l'une des revendications 8 ou 9, la gravure de la première couche supraconductrice pour former ledit via (108) étant arrêtée sur la surface supérieure de la première sous-couche (104₁, 204₁) en un premier matériau supraconducteur.

11. Procédé selon l'une des revendications 8 à 10, l'étape d) de formation d'au moins une deuxième ligne (126, 126') comportant la formation préalable d'au moins un deuxième via (128, 128'), puis de la deuxième ligne (126, 126').

12. Procédé selon l'une des revendications 8 à 11, comportant en outre, entre l'étape c) et d), une étape d'enrobage de ladite première ligne (114) et un enrobage au moins partiel et/ou latéral dudit premier via (108) avec un matériau diélectrique (124), formant un deuxième substrat (120), ce matériau diélectrique (124) étant par exemple à constante diélectrique relative k <7 et/ou étant par exemple choisi parmi la liste suivante : SiN, SiCN, SiO₂, SiCOH ou SiCOH poreux.

13. Procédé selon la revendication 12, l'étape d) comportant :
- le dépôt sur le deuxième substrat (120) d'une deuxième couche supraconductrice (116) en au moins un matériau supraconducteur, d'une épaisseur au moins égale à l'épaisseur d'une deuxième ligne (126, 126'), et éventuellement d'un deuxième via (128, 128');
- la gravure de la deuxième couche supraconductrice (116) pour éventuellement former le deuxième via (128, 128'), et pour former au moins ladite deuxième ligne (116), en contact avec ledit premier via (108).

14. Procédé selon l'une des revendications 8 à 13, l'étape b) étant réalisée par gravure partielle de ladite couche supraconductrice, laissant intacte une partie de celle-ci.

15. Procédé selon l'une des revendications 8 à 14, l'étape c) étant réalisée par lithographie avec gravure totale des parties exposées de ladite couche supraconductrice jusqu'au substrat.
